## Europäisches Patentamt
## European Patent Office
## Office européen des brevets

(19)

(11) Veröffentlichungsnummer: **0 058 752**
**B1**

(12) **EUROPÄISCHE PATENTSCHRIFT**

(45) Veröffentlichungstag der Patentschrift:
13.02.85

(51) Int. Cl.⁴: **H 03 K 5/135, H 03 K 3/037**

(21) Anmeldenummer: **81108592.7**

(22) Anmeldetag: **20.10.81**

(54) **Verfahren und Anordnung zur fehlerfreien Synchronisation asynchroner Impulse.**

(30) Priorität: **19.02.81 DE 3106183**

(43) Veröffentlichungstag der Anmeldung:
**01.09.82 Patentblatt 82/35**

(45) Bekanntmachung des Hinweises auf die Patenterteilung:
**13.02.85 Patentblatt 85/7**

(84) Benannte Vertragsstaaten:
**AT BE CH DE FR GB LI NL**

(56) Entgegenhaltungen:
**FR - A - 2 299 767**
**GB - A - 1 169 849**
**US - A - 3 971 960**

(73) Patentinhaber: **Siemens Aktiengesellschaft, Berlin und München Wittelsbacherplatz 2, D-8000 München 2 (DE)**

(72) Erfinder: **Wagner, Wolfgang, Dipl.-Ing., Wachenheimer Strasse 15, D-8000 München 90 (DE)**

BUNDESDRUCKEREI BERLIN

**Beschreibung**

Die Erfindung betrifft ein Verfahren und eine Anordnung zur fehlerfreien Synchronisation asynchroner Impulse durch logisches Verknüpfen der asynchronen Impulse mit Taktimpulsen konstanter Frequenz mittels eines Flip-Flops, dessen Ausgangsspannungen zum Ermitteln eines metastabilen Zustands mit einer vorgegebenen Schwellenspannung verglichen werden.

Solche Verfahren, bei denen das zu synchronisierende Signal z. B. am D-Eingang und der Systemtakt $\Phi$ am C-Eingang eines einflankengetriggerten D-Flip-Flops angeschlossen werden, sind aus U. Tietze und Ch. Schenk, Halbleiter-Schaltungstechnik, 5. Auflage, 1980, Seite 514, bekannt.

Liegen die Flanken des zu synchronisierenden (d. h. in der Regel asynchronen) Signals zeitlich gesehen in der Nähe der triggernden Taktflanke, so ist es möglich, daß das Flip-Flop nicht vollständig in einen der beiden stabilen Zustände kippt und dann für längere Zeit in einem instabilen bzw. metastabilen Zustand bleibt. Dies kann bei einer Auswertung der Flip-Flop-Ausgänge kurz nach dem Auftreten der triggernden Taktflanke zu Fehlern führen.

Es wurde versucht — wie es z. B. aus C. Mead und L. Conway, Introductions to VLSI-Systems, Reading, Massachusetts: Addison-Wesley, 1980, S. 236—242, insbesondere S. 239 bekannt — dieses Problem dadurch zu lösen, daß das am Flip-Flop-Ausgang anliegende synchronisierte Signal für eine bestimmte Zeit $t_s$ nach der Synchronisierungs-Taktflanke nicht beachtet wird. Die Wahrscheinlichkeit dafür, daß der instabile Zustand länger als $t_s$ erhalten bleibt, nimmt mit steigender Zeit t exponentiell ab.

Ohne Berücksichtigung des Rauschens, durch welches noch geringere Wahrscheinlichkeiten erreicht werden, gilt für die Wahrscheinlichkeit W

$$W = e^{-kt_s}, \text{mit } k = \text{Konstante.}$$

Durch entsprechende Wahl von $t_s$ kann somit die Fehlerwahrscheinlichkeit auf ein tolerierbares Maß herabgesetzt werden. Wegen des negativen Einflusses der Wartezeit $t_s$ auf die Verarbeitungsgeschwindigkeit — die Wartezeit $t_s$ ist beispielsweise bei Mikrocomputeranwendungen zur Speichergeschwindigkeit zu addieren — muß ein an und für sich unerwünschter Kompromiß zwischen Geschwindigkeit und Sicherheit eingegangen werden.

Wie aus dem Artikel von M. Pěchouček, Anomalous Response Times of Input Synchronizers, IEEE Transactions on Computers, Feb. 1976, S. 133—139 bekannt, ist das Problem auch dadurch lösbar, daß beim Auftreten eines metastabilen Zustandes der, den Systemtakt liefernde Taktgenerator für eine, der zeitlichen Maximaldauer eines metastabilen Zustandes entsprechende Zeit angehalten wird. Ein solches Verfahren ist jedoch bei Verwendung von Quarzoszillatoren nicht anwendbar und damit ungenau. Insbesondere ist ein solches Verfahren für eine Anwendung in dynamischen Systemen, die gewisse Schaltzeiten einhalten müssen, ungeeignet.

Ferner ist aus der US-PS 3 971 960, ebenso wie aus der GB-PS 169 849 eine Flip-Flop-Schaltung bekannt, deren Ausgangssignale einer Schwellwertschaltung zugeführt sind. Diese dient dazu, die Ausgangssignale so lange zu unterdrücken, bis sie einen von zwei eindeutigen Signalpegeln erreicht haben. Das bedeutet, daß der Zustandswechsel von einem instabilen in einen stabilen Zustand zeitlich unkontrolliert erfolgt. Somit besteht die Gefahr, daß der Wechsel zu einem unerlaubten Zeitpunkt, beispielsweise zwischen zwei Taktflanken erfolgt, was zu Fehlern führen kann.

Der Erfindung lag daher die Aufgabe zugrunde, ein Kippen des Ausgangssignals von einem instabilen in einen stabilen Zustand zu einem unerlaubten Zeitpunkt zu verhindern.

Diese Aufgabe wird in einem Verfahren der eingangs genannten Art erfindungsgemäß dadurch gelöst, daß bei Vorliegen eines metastabilen Zustands das aus kreuzförmig rückgekoppelten NOR-Gattern ausgeführte Flip-Flop bis zum Auftreten des nächsten Taktimpulses in einem dritten stabilen Zustand, der eine Auswertung der Ausgangsspannung des Flip-Flops verhindert, gehalten wird, und der dadurch erkannt wird, daß die Ausgangssignale des Flip-Flops über einen Schwellwertdetektor auf die Gatter des Flip-Flops rückgekoppelt wird.

Eine Anordnung zur Durchführung dieses Verfahrens wird vorteilhafterweise so ausgeführt, daß dem aus kreuzförmig rückgekoppelten NOR-Gattern ausgeführten Flip-Flop ein Slave-Flip-Flop nachgeschaltet ist, und daß als Rückkopplung und Schwellwertdetektor ein Schmitt-Trigger Gatter vorhanden ist, dessen Eingänge mit je einem Ausgang des Flip-Flops verbunden sind, und dessen Ausgang die Gatter des Flip-Flops eingangsseitig beaufschlagt.

Ausgestaltungen der erfindungsgemäßen Anordnung sind in Unteransprüchen gekennzeichnet.

Die Erfindung wird im folgenden anhand der Figuren näher erläutert. Dabei zeigt:

Die Fig. 1 ein als Ausführungsbeispiel zu wertendes Schaltbild einer Anordnung zur Durchführung des erfindungsgemäßen Verfahrens,

die Fig. 2 die Kennlinien eines beim Schaltbild der Fig. 1 verwendeten Master-Flip-Flops, und

die Fig. 3 die Kennlinie eines beim Ausführungsbeispiel nach Fig. 1 verwendeten Schmitt-Trigger-Gatters.

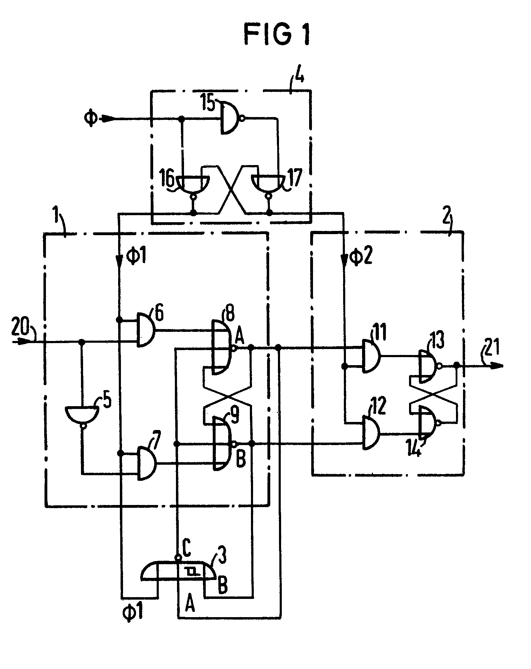

Im in der Fig. 1 gezeigten Ausführungsbeispiel wird zur Synchronisierung in an sich bekannter Weise ein Master-Slave-Flip-Flop (Master-Slave-FF), das aus einem vom Takt $\Phi_1$ gesteuerten Master-FF 1 und einem vom Takt $\Phi_2$ gesteuerten Slave-FF 2 besteht, verwendet. Die zwei, sich nicht überlappenden Takte $\Phi_1$ und $\Phi_2$, die

das Master-Slave-FF benötigt, können beispielsweise mittels der Schaltung 4 aus einem einzigen Systemtakt erzeugt werden. Die Schaltung 4 kann z. B. so ausgeführt sein, daß der Systemtakt $\Phi$ eingangsseitig einerseits ein NOR-Gatter 16 und über den Inverter 15 invertiert ein zweites NOR-Gatter 17 beaufschlagt und daß der Ausgang des NOR-Gatters 16 mit dem zweiten Eingang des NOR-Gatters 17 und der Ausgang des NOR-Gatters 17 mit dem zweiten Eingang des NOR-Gatters 16 verbunden ist. Der Takt $\Phi_1$ ist dann am Ausgang des Gatters 16 und der Takt $\Phi_2$ am Ausgang des Gatters 17 abnehmbar.

Das Master-FF 1 besteht im gezeigten Ausführungsbeispiel aus Eingangsgattern 6, 7 und rückgekoppelten Ausgangsgattern 8, 9. Das asynchrone, zu synchronisierende Eingangssignal 20 wird einerseits direkt dem ersten Eingang eines UND-Gatters 6, dessen zweiter Eingang vom Takt $\Phi_1$ beaufschlagt wird, und andererseits über den Inverter 5 invertiert dem ersten Eingang eines UND-Gatters 7, dessen zweiter Eingang ebenfalls vom Takt $\Phi_1$ beaufschlagt wird, zugeführt. Der Ausgang des UND-Gatters 6 ist mit einem Eingang des NOR-Gatters 8, der Ausgang des UND-Gatters 7 mit einem Eingang des NOR-Gatters 9 verbunden. Die beiden NOR-Gatter 8 und 9 sind in der Weise rückgekoppelt, daß der Ausgang A des Gatters 8 mit einem weiteren Eingang des Gatters 9 und der Ausgang B des Gatters 9 mit einem weiteren Eingang des Gatters 8 verbunden sind.

Das Slave-FF 2 weist zwei UND-Gatter 11 und 12, die eingangsseitig vom Takt $\Phi_2$ beaufschlagt werden, auf. Der zweite Eingang des Gatters 11 ist mit dem Ausgang A des NOR-Gatters 8 und der zweite Eingang des Gatters 12 mit dem Ausgang B des NOR-Gatters 9 verbunden. Ausgangsseitig ist das Gatter 11 mit einem ersten Eingang des NOR-Gatters 13 und das Gatter 12 mit einem ersten Eingang des NOR-Gatters 14 verbunden. Die beiden Gatter 13 und 14 sind in der, der Schaltung der Gatter 8 und 9 entsprechenden Weise rückgekoppelt. Das einsynchronisierte Signal 21 ist am Ausgang des Gatters 13 abnehmbar.

Um die Durchführung des erfindungsgemäßen Verfahrens zu ermöglichen, ist die oben geschilderte Synchronisierschaltung durch ein Schmitt-Trigger-Gatter 3 erweitert. Der erste Eingang des als NOR-Gatters ausgeführten Schmitt-Trigger-Gatters 3 ist mit dem Ausgang A des Ausgangsgatters 8 des Master-FF 1, der zweite Eingang mit dem Ausgang B des Ausgangsgatters 9 des Master-FF 1 und der dritte Eingang mit dem Takt $\Phi_1$ verbunden. Der Ausgang des Schmitt-Trigger-Gatters 3 ist einerseits mit einem dritten Eingang des Gatters 8 und andererseits mit einem dritten Eingang des Gatters 9 verbunden.

Durch diese Schaltungsordnung gelingt es, Fehler, die durch den instabilen Zustand des Flip-Flops 1 entstehen können, zu vermeiden, da der instabile Zustand erkannt wird und zur Verhinderung der Auswertung der Flip-Flop-Ausgänge A und B führt. Da eine exakte Erkennung des instabilen Zustandes nur mit hohem Aufwand durchzuführen ist, wird durch Vergleich der FF-Ausgänge A und B mit der unteren Trigger-Schwelle des Schmitt-Trigger-Gatters 3 der um den instabilen Punkt herumliegende »entscheidungsunwillige« bzw. metastabile Bereich erkannt und eine Verhinderung gestartet, wenn das Master-FF 1 in diesem Bereich arbeitet. Da auch ein nachträgliches Kippen des Master-FF 1 vom instabilen in einen stabilen Zustand beispielsweise durch eine Verkürzung des Ausgangssignals zu Fehlern führen kann, muß eine begonnene Verhinderung bis zur nächsten Flanke des Taktes $\Phi_1$ erhalten bzw. gespeichert bleiben. Diese Speicherung der Verhinderungsanforderung darf nicht in einem eigenen FF erfolgen, da dieses FF wiederum im instabilen Zustand verharren kann, sondern wird erfindungsgemäß als dritter stabiler Zustand des als Synchronisations-FF wirkenden Master-FF 1 realisiert.

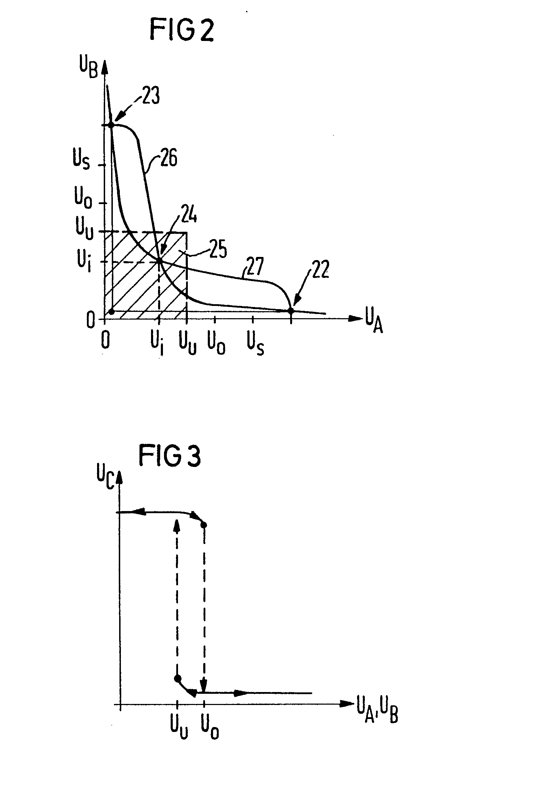

Die Fig. 2 zeigt zur Erläuterung der Begriffe »entscheidungsunwilliger« bzw. metastabiler Bereich und instabiler Punkt die Kennlinien des Master-FF 1. Die Kennlinie 26 des Gatters 9 und die Kennlinie 27 des Gatters 8 schneiden sich in den beiden »stabilen« Punkten 22 und 23 und im »instabilen« Punkt 24. Mit $U_B$ ist die Ausgangsspannung des Gatters 9 und die Eingangsspannung des Gatters 8 und mit $U_A$ die Eingangsspannung des Gatters 9 und die Ausgangsspannung des Gatters 8 bezeichnet. Sind beide Spannungen $U_A$ und $U_B$ identisch, so bleibt das FF 1 instabil, anderenfalls wird nach einer gewissen Zeit ein stabiler Punkt erreicht. In der Fig. 2 bedeuten weiterhin

| | | |
|---|---|---|
| $U_i$ | : | instabiler Punkt der Ausgangsspannung |
| $U_u$ | : | untere Triggerschwellenspannung des Schmitt-Trigger-Gatters 3 |
| $U_o$ | : | obere Triggerschwellenspannung des Schmitt-Trigger-Gatters 3 |
| $U_s$ | : | Schwellenspannung des Slave-FF 2. |

Die Größe des in der Fig. 2 schraffiert dargestellten, »entscheidungsunwilligen« Bereiches 25, der von der erfindungsgemäßen Schaltung erkannt wird, kann durch die Wahl der unteren Triggerschwellenspannung $U_u$ gewählt werden. Im einzelnen arbeitet die in der Fig. 1 gezeigte Schaltung wie folgt:

Während der Takt $\Phi_1$ aktiv (»high«) ist, wird die asynchrone Information in das Master-FF 1 übernommen und das am Ausgang des Schmitt-Trigger-Gatters 3 anliegende Sperrsignal C unterdrückte (C=»low«). Nach der abfallenden Flanke des Taktes $\Phi_1$ werden keine Daten mehr vom FF 1 angenommen. Ist eine der an den Ausgängen A bzw. B anliegenden Spannungen $U_A$ oder $U_B$ niedriger als die untere Trigger-Schwelle $U_u$ des Schmitt-Trigger-Gatters 3, so arbeitet das Master-FF 1 im entscheidungsunwilligen Bereich, das Sperrsignal C bleibt »low« und ab der steigenden Flanke des Taktes $\Phi_2$ übernimmt das Slave-FF 2 den (stabilen) Inhalt des Master-FF 1.

Falls das Master-FF 1 durch eine kritische Bedingung während der fallenden Flanke des Taktes $\Phi_1$ im entscheidungsunwilligen Bereich 25 arbeitet (Vergl. Fig. 2), so spricht das Schmitt-Trigger-Gatter 3 an (C = »high«) und sperrt über das Signal C beide Ausgänge des Master-FF 1. Dadurch wird der gewünschte dritte stabile Zustand des Master-FF 1 realisiert.

Da nun beide an den Ausgängen A des Gatters 8 und B des Gatters 9 anliegenden Signale passiv (low) sind, übernimmt das Slave-FF 2 in der $\Phi_2$-Taktphase keine neuen Daten, sondern speichert weiterhin den alten Inhalt. Dies ist zulässig und führt zu keinen Fehlern, da ein metastabiles Verhalten nur auftritt, wenn eine Flanke des Eingangssignals 20 und eine Synchronisierungs-Flanke des Taktes $\Phi_1$ zeitlich zusammentreffen und in diesem Fall beide Zustände des Slave-FF 2 möglich, d. h. für die Weiterverarbeitung erlaubt, sind.

Durch das erfindungsgemäße Verfahren werden somit Synchronisierfehler vermieden. Zugleich wird wegen des Wegfalls der bei aus dem Stand der Technik bekannten Verfahren notwendigen Wartezeit $t_s$ eine optimale Geschwindigkeit erreicht.

Eine entsprechend der Fig. 1 ausgeführte Schaltung ist vorteilhafterweise in MOS-Technologie zu realisieren. Die Dimensionierung der Schaltung sollte so durchgeführt werden, daß die in Fig. 2 und in der, die Kennlinie des Schmitt-Trigger-Gatters 3 zeigenden Fig. 3 mit $U_u$ bezeichnete untere Triggerschwellenspannung des Schmitt-Trigger-Gatters 3 oberhalb des instabilen Punktes 24 des Master-FF 1 liegt. Die Schwellenspannung des Slave-FF 2 muß über der oberen Triggerschwellenspannung $U_o$ des Schmitt-Trigger-Gatters 3 liegen. Vorteilhafterweise weist das Master-FF 1 eine relativ große Verstärkung auf. Die ansteigenden Flanken der Ausgänge A und B des Master-FF 1 sollten zur Verhinderung einer Schwingungsneigung langsamer ansteigen als die ansteigende Flanke des Sperrsignals C. Der dritte Eingang des Schmitt-Trigger-Gatters 3, der vom Takt $\Phi_1$ beaufschlagt wird, muß im Gegensatz zu den mit den Ausgängen A und B verbundenen Eingängen keine Hysterese aufweisen. Seine Schaltschwelle sollte aber im Vergleich zur Schaltschwelle der Eingangs-UND-Gatter 6 und 7 relativ hoch liegen.

**Patentansprüche:**

1. Verfahren zur fehlerfreien Synchronisation asynchroner Impulse durch logisches Verknüpfen der asynchronen Impulse mit Taktimpulsen ($\Phi_1$) konstanter Frequenz mittels eines Flip-Flops (1), dessen Ausgangsspannungen zum Ermitteln eines metastabilen Zustandes mit einer vorgegebenen Schwellenspannung verglichen werden, dadurch gekennzeichnet, daß bei Vorliegen eines metastabilen Zustandes das aus kreuzförmig rückgekoppelten NOR-Gattern (8, 9) ausgeführte Flip-Flop (1) bis zum Auftreten des nächsten Taktimpulses ($\Phi_1$) in einem dritten stabilen Zustand, der eine Auswertung der Ausgangsspannungen des Flip-Flops (1) verhindert, gehalten wird, und der dadurch erkannt wird, daß die Ausgangssignale des Flip-Flops (1) über einen Schwellwertdetektor auf die Gatter (8, 9) des Flip-Flops (1) rückgekoppelt werden.

2. Anordung zur Durchführung des Verfahrens nach Anspruch 1, mit einem von asynchronen Impulsen beaufschlagten und von Taktimpulsen ($\Phi_1$) gesteuerten Flip-Flop (1), an dessen Ausgängen (A, B) das synchronisierte Signal entnehmbar ist, dadurch gekennzeichnet, daß dem aus kreuzförmig rückgekoppelten NOR-Gattern (8, 9) ausgeführten Flip-Flop (1) ein Slave-Flip-Flop (2) nachgeschaltet ist, und daß als Rückkopplung und Schwellwertdetektor ein Schmitt-Trigger-Gatter (3) vorhanden ist, dessen Eingänge mit je einem Ausgang (A, B) des Flip-Flops (1) verbunden sind, und dessen Ausgang die Gatter (8, 9) des Flip-Flops (1) eingangsseitig beaufschlagt.

3. Anordnung nach Anspruch 2, dadurch gekennzeichnet, daß das Schmitt-Trigger-Gatter (3) einen weiteren, von den Taktimpulsen ($\Phi_1$) beaufschlagbaren Eingang aufweist.

4. Anordnung nach Anspruch 2 oder 3, dadurch gekennzeichnet, daß das Schmitt-Trigger-Gatter (3) als NOR-Gatter ausgeführt ist.

**Claims**

1. A process for a fault-free synchronisation of asynchronous pulses by logic linking of the asynchronous pulses with clock pulses ($\Phi_1$) of constant frequency by means of a flip-flop (1) whose output voltages are compared with a predetermined threshold voltage in order to determine a metastable state, characterised in that when a metastable state prevails the flip-flop (1), which in constructed from NOR-gates (8, 9) provided with cross-wise feedback are held, until the occurrence of the next clock pulse ($\Phi_1$), in a third stable state which prevents the analysis of the output voltages of the flip-flop (1), and which is recognised in that the output signals of the flip-flop (1) are fed-back via a threshold value detector to the gates (8, 9) of the flip-flop (1).

2. An arrangement for the execution of the process claimed in Claim 1, with a flip-flop (1) fed with asynchronous pulses, controlled by clock pulses ($\Phi_1$), and from whose outputs (A, B) the synchronised signal can be withdrawn, characerised in that the flip-flop (1) is constructed of NOR-gates (8, 9) provided with cross-wise feedback followed by a slave flip-flop (2), and that by way of feedback and threshold detector a Schmitt trigger stage (3) is provided whose inputs are each connected to an output (A, B) of the flip-flop (1) and whose output is connected to the gates (8, 9) of the flip-flop (1) at the input end.

3. An arrangement as claimed in Claim 2, characterised in that the Schmitt trigger stage (3) possesses a further input which can be supplied with the clock pulses ($\Phi_1$).

4. An arrangement as claimed in Claim 2 or 3, characterised in that the Schmitt trigger stage (3) is constructed as a NOR-gate.

## Revendications

1. Procédé pour la synchronisation d'impulsions asynchrones par combinaison logique des impulsions asynchrones avec des impulsions de cadence ($\Phi 1$) de fréquence constante à l'aide d'un multivibrateur bistable (1), dont les tensions de sortie sont comparées avec une tension de seuil en vue de détecter un état métastable, caractérisé par le fait que dans le cas de la présence d'un état métastable, le multivibrateur bistable (1) que est réalisé par des portes NI (8, 9) à contre-réaction du type croisée est maintenu jusqu'à l'apparition de l'impulsion de cadence ($\Phi 1$) suivante, dans un troisième état stable que empêche une évaluation des tensions de sortie du multivibrateur bistable (1), et que est reconnu par le fait que les signaux du multivibrateur bistable (1) sont réinjectés, par l'intermédiaire d'un détecteur à valeur de seuil dans les portes (8, 9) du multivibrateur bistable (1).

2. Dispositif pour la mise en oeuvre du procédé selon la revendication 1, avec un multivibrateur bistable (1) recevant des impulsions asynchrones et commandé par des impulsions de cadence ($\Phi 1$), multivibrateur bistable aux sorties (A, B) duquel le signal synchronisé peut être prélevé, caractérisé par le fait qu'en aval du multivibrateur bistable (1) qui est réalisé par des portes NI (8, 9) à contre-réaction croisée, est monté un multivibrateur bistable esclave (2), et qu'au titre de contre-réaction et de détecteur à valeur de seuil il est prévu une porte (3) à bascule de Schmitt, dont les entrées sont respectivement reliées à des sorties (A, B) du multivibrateur bistable (1), et dont la sortie charge, du côte entrée, les portes (8, 9) du multivibrateur bistable (1).

3. Dispositif selon la revendication 2, caractérisé par le fait que la porte (3) à bascule de Schmitt comporte une entrée supplémentaire que est susceptible d'être chargée par les impulsions de cadence ($\Phi 1$).

4. Dispositif selon les revendications 2 ou 3, caractérisé par le fait que la porte (3) à bascule de Schmitt est réalisée sous la forme d'une porte NI.

FIG 1

## FIG 2

## FIG 3